# EUROPEAN PATENT APPLICATION

(11) **EP 4 362 116 A1**
(43) Date of publication of application: **01.05.2024**
(21) Application number: 22828182.0
(22) Date of filing: 02.06.2022
(51) Int. Cl.: H01L 33/56, H01L 33/60

(54) **LIGHT-EMITTING DEVICE, METHOD FOR MANUFACTURING LIGHT-EMITTING DEVICE, LIGHT-REFLECTING MATERIAL, AND IRRADIATION DEVICE**

(30) Priority: 23.06.2021 JP 2021104046
(71) Applicant: STANLEY ELECTRIC CO., LTD., Tokyo 153-8636 (JP)
(72) Inventor: YAMASHITA, Yusuke, Tokyo 153-8636 (JP); TABUCHI, Kenji, Tokyo 153-8636 (JP)
(74) Representative: Wimmer, Hubert
(86) International application number: PCT/JP2022/022445
(87) International publication number: WO 2022/270264

(57) **Abstract**

A light-emitting device includes a substrate, a light-emitting element, and a resin material. The light-emitting element is disposed on the substrate. The resin material is made of a translucent thermosetting resin disposed at a peripheral area of the light-emitting element. The resin material has a plurality of closed spaces, and each of the plurality of closed spaces holds a resin body.

## Description

### TECHNICAL FIELD

The present invention relates to a light-emitting device, a manufacturing method of the light-emitting device, a light-reflective material, and an irradiation device.

### BACKGROUND ART

As a small-sized light-emitting device in which a light-emitting element, such as a light-emitting diode (LED), is used as a light source, there has been known a light-emitting device constituted of a mounting board, a light-emitting element disposed on the mounting board, and a light-reflective resin body disposed to cover a side surface of the light-emitting element.

For example, Patent Document 1 discloses an optoelectronic semiconductor component that includes a carrier, an optoelectronic semiconductor chip disposed on the carrier, a covering body mounted on a main radiation surface of the optoelectronic semiconductor chip, and a reflective potting compound covering side surfaces of the optoelectronic semiconductor chip and the covering body.

Patent Document 1: Japanese Unexamined Patent Application Publication (Translation of PCT Application) No. 2013-535111

### DISCLOSURE OF THE INVENTION

### PROBLEMS TO BE SOLVED BY THE INVENTION

In the optoelectronic semiconductor component disclosed in Patent Document 1, a permeable silicone material in which reflective particles made of titanium oxide are embedded is used as the potting compound. However, decomposition of resin is known to occur by photocatalytic action that the titanium oxide contained in the potting compound has. The titanium oxide in the potting compound may exert photocatalytic action by the light from the optoelectronic semiconductor chip or the covering body, accelerate deterioration of resin, such as a silicone material, and cause yellowing of the silicone material, resin reduction due to cracks and depolymerization, and the like. This may impair long-term reliability of an optical property in the optoelectronic semiconductor component.

In addition, when the concentration of reflected particles, such as metal particles, in the silicone material is increased in order to improve a reflection characteristic of the potting compound, the elastic modulus of the silicone material after being cured may decrease, causing, for example, cracks of the silicone material and flaking from the carrier and the like, and the long-term reliability of the optoelectronic semiconductor component may be impaired.

The present invention has been made in consideration of the above-described points, and an object of which is to provide a light-emitting device, a manufacturing method of the light-emitting device, a light-reflective material, and an irradiation device that allow suppressing deterioration of a light-reflective resin body and improving long-term reliability.

### SOLUTIONS TO THE PROBLEMS

A light-emitting device according to the present invention includes a substrate, a light-emitting element, and a resin material. The light-emitting element is disposed on the substrate. The resin material is made of a translucent thermosetting resin disposed at a peripheral area of the light-emitting element. The resin material has a plurality of closed spaces, and each of the plurality of closed spaces holds a resin body.

A manufacturing method of a light-emitting device including a substrate, a light-emitting element disposed on the substrate, and a wavelength converter disposed on an upper surface of the light-emitting element according to the present invention includes: a dispersion step of dispersing a resin body having a coating containing a higher alcohol in a resin material made of a translucent thermosetting resin; a resin material arranging step of arranging the resin material at a peripheral area of the light-emitting element on the substrate; and a heating processing step of heating and curing the resin material and evaporating the higher alcohol to form a closed space in the resin material.

A manufacturing method of a light-emitting device including a substrate and a light-emitting element disposed on the substrate according to the present invention includes: a dispersion step of dispersing thermally expandable particles in a resin material made of a translucent thermosetting resin; a resin material arranging step of arranging the resin material at a peripheral area of the light-emitting element on the substrate; and a heating processing step of heating and curing the resin material and expanding the thermally expandable particles to form a closed space in the resin material.

A light-reflective material according to the present invention includes a translucent thermosetting resin having a plurality of closed spaces. Each of the plurality of closed spaces holds a resin body.

An irradiation device according to the present invention includes a light source; and a light-reflective material disposed at a position on which light emitted from the light source is incident. The light-reflective material is made of a translucent thermosetting resin having a plurality of closed spaces, and each of the plurality of closed spaces holds a resin body.

### BRIEF DESCRIPTION OF THE DRAWINGS

FIG. 1 is a top view of a light-emitting device according to Embodiment 1 of the present invention.
FIG. 2 is a cross-sectional view of the light-emitting device according to Embodiment 1 of the present invention.
FIG. 3 is an enlarged cross-sectional view of an enlarged part of a resin material and a plurality of closed spaces of the light-emitting device according to Embodiment 1 of the present invention.
FIG. 4 is a diagram illustrating a manufacturing process of the light-emitting device according to Embodiment 1 of the present invention.
FIG. 5 is a diagram illustrating a forming method of holes of the light-emitting device according to Embodiment 1 of the present invention.
FIG. 6 is a diagram illustrating the forming method of the holes of the light-emitting device according to Embodiment 1 of the present invention.
FIG. 7 is an enlarged cross-sectional view of an enlarged part of a resin material and a plurality of closed spaces of a light-emitting device according to Embodiment 2 of the present invention.
FIG. 8 is a diagram illustrating a forming method of holes of the light-emitting device according to Embodiment 2 of the present invention.
FIG. 9 is a diagram illustrating the forming method of the holes of the light-emitting device according to Embodiment 2 of the present invention.
FIG. 10 is a diagram illustrating the forming method of the holes of the light-emitting device according to Embodiment 2 of the present invention.
FIG. 11 is a diagram illustrating a cross-sectional view of a vehicle lamp as an example of an irradiation device in which a light-reflective material of the present invention is used.

### DESCRIPTION OF PREFERRED EMBODIMENTS

The following describes embodiments of the present invention in detail. In the following description and attached drawings, same reference numerals are given to actually same or equivalent parts.

### Embodiment 1

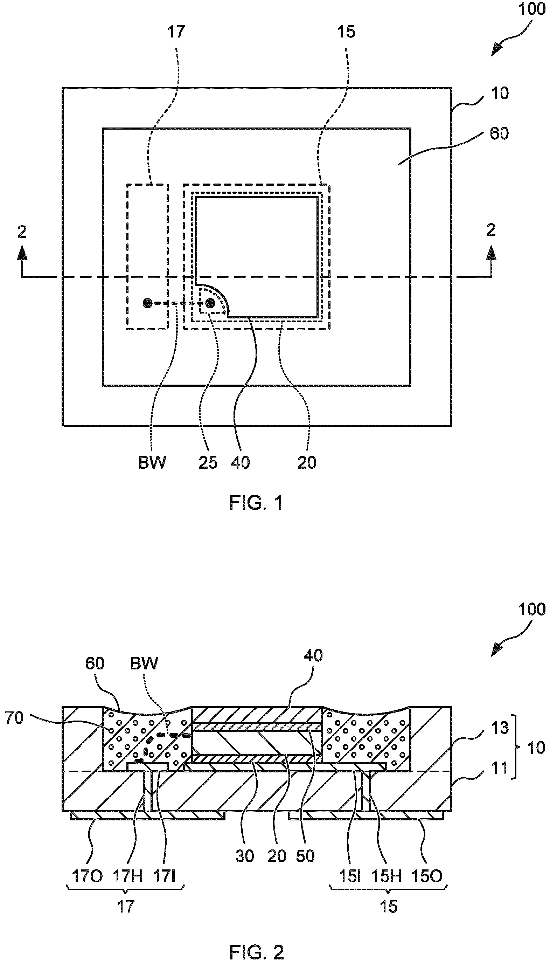

A configuration of a light-emitting device 100 according to Embodiment 1 is described with reference to FIG. 1 to FIG. 3.

FIG. 1 is a top view of the light-emitting device 100 according to Embodiment 1. FIG. 2 is a cross-sectional view taken along the line 2-2 of the light-emitting device 100 illustrated in FIG. 1.

The light-emitting device 100 has a substrate 10, a light-emitting element 20, and a wavelength converter 40. The substrate 10 has a recessed cavity on an upper surface and a first wiring 15 and a second wiring 17 that are formed on a bottom surface of the cavity. The light-emitting element 20 is disposed on the first wiring 15. The wavelength converter 40 is disposed on an upper surface of the light-emitting element 20. The light-emitting device 100 further has a resin material 60 filled in the cavity.

For example, the substrate 10 is a substrate made of ceramic, such as aluminum nitride (AlN), silicon nitride (SiN), and alumina (Al₂O₃), having high thermal conductivity. The substrate 10 is, for example, constituted of a flat plate-shaped flat plate portion 11 and a frame body portion 13 that has an outer peripheral shape similar to an upper surface of the flat plate portion 11 and an opening portion passing through from an upper surface to a lower surface in an inner edge portion. That is, the substrate 10 has a recessed cavity having a bottom portion that is the upper surface of the flat plate portion 11 and constituted of the upper surface of the flat plate portion 11 and inner side surfaces of the frame body portion 13.

In Embodiment 1, the flat plate portion 11 and the frame body portion 13 are integrally formed. That is, the substrate 10 is a substrate formed by processing one base material. In the substrate 10, the flat plate portion 11 and the frame body portion 13 may be separately formed, and the flat plate portion 11 and the frame body portion 13 may be bonded via an adhesive and the like. In that case, the flat plate portion 11 and the frame body portion 13 may be made of different members.

The first wiring 15 and the second wiring 17 are formed on the substrate 10 separately from one another. The first wiring 15 and the second wiring 17 are constituted of first and second internal wirings 151 and 171, first and second through wirings 15H and 17H formed so as to pass through from the upper surface to the lower surface of the flat plate portion 11, and first and second external wirings 15O and 17O formed on the lower surface of the flat plate portion 11. The first and second internal wirings 151 and 17I are formed on the upper surface of the flat plate portion 11, that is, the bottom surface of the cavity of the substrate 10. The first and second internal wirings 15I and 17I are electrically connected to the first and second external wirings 15O and 17O with the first and second through wirings 15H and 17H.

The first wiring 15 and the second wiring 17 are, for example, metal wiring made of metal, such as silver alloy and copper (Cu). A metal film of nickel/gold (Ni/Au) is formed on surfaces of the first wiring 15 and the second wiring 17.

The first internal wiring 15I functions as an element placement portion having an upper surface on which the light-emitting element 20 is placed. The respective first and second external wirings 15O and 17O function as mounting electrodes when mounted on a mounting substrate. That is, in the substrate 10, the bottom surface of the cavity on which the first and second internal wirings 15I and 17I are formed functions as an element placement surface of the light-emitting device 100, and the lower surface of the substrate 10 functions as a mounting surface for a mounting substrate of the light-emitting device 100. A cavity formed surface that is the upper surface of the substrate 10 functions as a light-radiating surface of the light-emitting device 100.

For example, the light-emitting element 20 is a light-emitting element, such as a light-emitting diode (LED) element, placed on the first wiring 15 of the substrate 10. In other words, the light-emitting device 100 includes the light-emitting element 20 disposed on the substrate 10.

For example, the light-emitting element 20 is constituted of a structure in which a semiconductor layer (not illustrated) constituted of a p-type semiconductor layer, an active layer, and an n-type semiconductor layer and a reflecting electrode constituted of a plurality of metal layers are bonded together on a supporting substrate made mainly of a conductive semiconductor of silicon or the like. In the semiconductor layer, for example, the reflecting electrode, the p-type semiconductor layer, the active layer, and the n-type semiconductor layer are laminated in this order via a conductive bonding member from an upper surface of the supporting substrate. In Embodiment 1, the p-type semiconductor layer, a light-emitting layer, and the n-type semiconductor layer are, for example, nitride semiconductors made mainly of gallium nitride (GaN) or the like and a blue LED that radiates blue light from the light-emitting layer having a multiple quantum well structure. Further, the n-type semiconductor layer has an upper surface that is an upper surface of the semiconductor layer and functions as a light-radiating surface in the light-emitting element 20.

The n-type semiconductor layer in the semiconductor layer is electrically connected to the supporting substrate of the light-emitting element 20, and a lower surface of the light-emitting element 20 functions as a cathode electrode. The cathode electrode that is the lower surface of the light-emitting element 20 is electrically connected to the first internal wiring 15I via a conductive element bonding layer 30.

An electrode pad 25 formed separately from the semiconductor layer is formed on the upper surface of the light-emitting element 20. The electrode pad 25 is electrically connected to the p-type semiconductor layer in the semiconductor layer and functions as an anode electrode of the light-emitting element 20. For example, the electrode pad 25 is electrically connected to the second internal wiring 17I via a conductive bonding wire BW made of gold (Au). That is, in the light-emitting device 100, the first external wiring 15O functions as the cathode electrode of the light-emitting device 100, and the second external wiring 17O functions as the anode electrode of the light-emitting device 100.

The element bonding layer 30 is, for example, a conductive adhesive. For example, a raw material of the element bonding layer 30 is a paste in which gold-tin (Au-Sn) alloy particles are mixed. The paste is applied over the first internal wiring 15I, and the cathode electrode of the light-emitting element 20 is placed so as to come into contact with an upper surface of the paste and processed by heating.

The heating process melts Au-Sn particles contained in the paste, causing eutectic reaction with an Au layer on a surface of the first internal wiring 15I, and the light-emitting element 20 and the first internal wiring 15I are joined by eutectic bonding. The material of the element bonding layer 30 is not limited to the Au-Sn paste, and a material, such as a solder paste and silver paste, may be used.

The wavelength converter 40 is disposed on the light-emitting element 20 via an adhesive layer 50. The wavelength converter 40 contains phosphor particles that convert a wavelength of a part or a whole of the emission of light from the light-emitting element 20. The wavelength converter 40 is, for example, a sintered body containing phosphor particles made mainly of cerium (Ce) doped yttrium aluminum garnet (YAG:Ce, Y₃Al₅O₁₂:Ce) and a binder of ceramic, such as alumina (Al₂O₃), that transmits radiated light of the light-emitting element 20 and radiated light of the phosphor particles. In Embodiment 1, the wavelength converter 40 is a wavelength converter in which the phosphor particles convert the wavelength of a part of blue light radiated by the light-emitting element 20 and radiate white light.

The adhesive layer 50 is an adhesive made of a translucent resin material that transmits the light radiated from the light-emitting element 20 and the light radiated from the wavelength converter 40. The adhesive layer 50 is, for example, a thermosetting resin, such as a silicone resin.

The light radiated from the light-emitting element 20 enters an inside of the wavelength converter 40 from a lower surface of the wavelength converter 40 via the adhesive layer 50, has the wavelength converted inside the wavelength converter 40, and exits to an outside of the light-emitting device 100 from an upper surface of the wavelength converter 40. That is, in the wavelength converter 40, the lower surface functions as a light-receiving surface that receives the light radiated from the light-emitting element 20 via the adhesive layer 50, and the upper surface functions as a light-radiating surface of the light-emitting device 100.

The resin material 60 is filled inside the cavity formed with the flat plate portion 11 and the frame body portion 13 so as to seal the light-emitting element 20 and cover side surfaces of the wavelength converter 40. The resin material 60 is, for example, a translucent thermosetting resin, such as a silicone resin. In Embodiment 1, a case where the resin material 60 is a thermosetting silicone resin is described.

Inside the resin material 60, as illustrated in FIG. 2, a plurality of closed spaces 70 are formed in a dispersed manner.

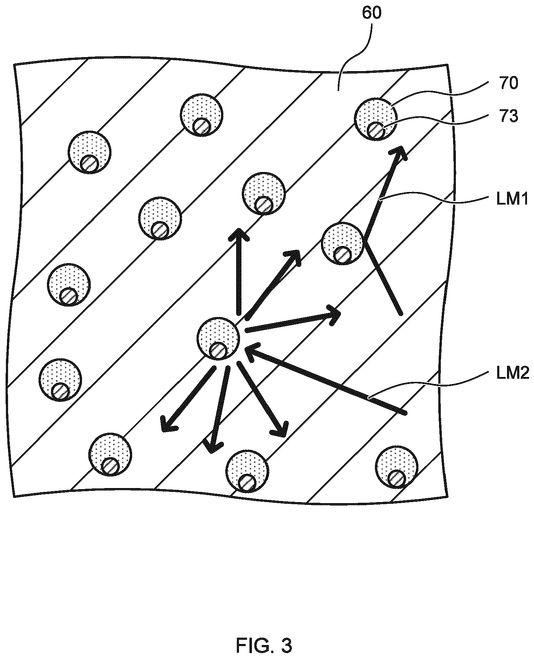

FIG. 3 is an enlarged cross-sectional view of an enlarged part of the resin material 60 and the plurality of closed spaces 70 of the light-emitting device 100 according to Embodiment 1.

Each of the plurality of closed spaces 70 preferably has an average diameter of 200 nm or more and 200 um or less and further preferably has an average diameter of 200 nm or more and 50 um or less. This is because the average diameter of less than 200 nm causes an intermolecular force and the aggregation of particles to become strong, and the average diameter exceeding 200 um makes controlling resin injection difficult. In the embodiment, each of the plurality of closed spaces 70 has, for example, an average diameter of approximately 200 nm to 300 nm, and each is formed in an approximately spherical shape. In each closed space 70, a resin body 73 is included, and a space that is in a gas state is formed in space from the resin body 73. In addition, insides of the plurality of closed spaces 70 contain an organic matter containing a higher alcohol. The organic matter can exist by, for example, adhering to the resin body 73 surface or adhering to an inner wall surface of the closed space 70 in the resin material 60. The higher alcohol included inside the plurality of closed spaces 70 is an organic matter that evaporates at a lower temperature than a thermal curing temperature of the resin material 60. Specifically, the higher alcohol included inside the plurality of closed spaces 70 is preferably matter that evaporates at a heating temperature that decreases a viscosity of the silicone resin used as the resin material 60. In other words, the plurality of closed spaces 70 internally include an organic matter. The organic matter included inside the plurality of closed spaces 70 is a higher alcohol. The organic matter included inside the plurality of closed spaces 70 is an organic matter that evaporates at a lower temperature than the thermal curing temperature of the resin material 60. Each of the plurality of closed spaces 70 has, for example, a diameter average value of 200 nm to 300 nm.

The resin body 73 having an outer shape smaller than a shape of each closed space 70 resides in the inside of each of the plurality of closed spaces 70. The resin body 73 is, for example, a silicone resin formed into an approximately spherical shape. In other words, the light-emitting device 100 includes the resin material 60 disposed at the peripheral area of the light-emitting element 20 and the wavelength converter 40. The resin material 60 has the plurality of closed spaces 70, each of which holds the resin body 73. The resin body 73 is a silicone resin.

The resin material 60 and the plurality of closed spaces 70 function as a light reflector that reflects the light radiated from the light-emitting element 20 and the light radiated from the wavelength converter 40.

The plurality of closed spaces 70 are formed during heat curing of the resin material 60 in a manufacturing method described below. Specifically, the resin bodies 73 are mixed so as to be dispersed in an uncured resin that is a precursor of the resin material 60. At this time, the resin bodies 73 are covered with a dispersant containing a higher alcohol. Afterwards, during heat curing of the precursor of the resin material 60, the higher alcohol contained in the dispersant evaporates at a lower temperature than the temperature at which the precursor of the resin material 60 is cured. The evaporated higher alcohol pushes to open up the resin material 60 at peripheral areas of the resin bodies 73 to form the closed spaces 70 at the peripheral areas of the resin bodies 73. By further heating and curing the precursor of the resin material 60 in a state where the closed spaces 70 are formed, the closed spaces 70 remain inside the resin material 60 after the heat curing.

The higher alcohol contained in the dispersant is preferably an organic matter that does not dissolve in the resin material 60 or the precursor of the resin material 60. Specifically, the dispersant is preferably an organic matter with which functional groups, such as alkyl groups or hydroxyl groups thereof are oriented in both the silicone resins that are the resin material 60 and the silicone resin as the resin bodies 73.

For example, when both the resin material 60 and the resin bodies 73 have hydrophobic properties, the dispersant is preferably configured to contain a lower alcohol and a higher alcohol. Consequently, between the resin bodies 73 and the precursor of the resin material 60, in the dispersant, the alkyl groups of the higher alcohol are oriented via the lower alcohol to respective surfaces of the resin bodies 73 and the precursor of the resin material 60. Specifically, in the dispersant, in an order from the resin body 73 side, the higher alcohol in which the alkyl groups are oriented to the resin body 73 and the hydroxyl groups are oriented to an outer side, the lower alcohol oriented to the hydroxyl groups of the higher alcohol, the higher alcohol in which the hydroxyl groups are oriented to the lower alcohol and the alkyl groups are oriented to the precursor of the resin material 60 are oriented in this order. That is, as the dispersant, a membranal dispersant in which the higher alcohol, the lower alcohol, and the higher alcohol are layered in this order can be configured, and dissolving of the dispersant into the precursor of the resin material 60 can be suppressed. Moreover, in the evaporated higher alcohol, since the alkyl groups are oriented to the surfaces of the resin bodies 73 and the precursor of the resin material 60, dissolving of the higher alcohol in a gas state into the precursor of the resin material 60 can be suppressed, and a variation in diameter due to shrinkage and the like of the closed spaces 70 can be suppressed.

Further, for example, when both the resin material 60 and the resin bodies 73 have hydrophilic properties, the dispersant is preferably configured to contain a low-molecular-weight hydrocarbon and a higher alcohol. Even in this case, between the resin bodies 73 and the precursor of the resin material 60, in the dispersant, each of the hydroxyl groups of the higher alcohol are oriented via the low-molecular-weight hydrocarbon to the respective surfaces of the resin bodies 73 and the precursor of the resin material 60. Accordingly, as the dispersant, similarly to the above-described case where both the resin material 60 and the resin bodies 73 have hydrophobic properties, a membranal dispersant in which the higher alcohol, the low-molecular-weight hydrocarbon, and the higher alcohol are layered in this order can be configured.

For the above-described reasons, both the resin material 60 and the resin bodies 73 are preferably made of resin materials having the same hydrophobic or hydrophilic polarity.

The following describes the functions of the resin material 60 and the plurality of closed spaces 70 as the light reflector.

As described above, the resin material 60 is a thermosetting silicone resin. That is, the resin material 60 has a refractive index ***n*** = approximately 1.4 to 1.55. As described above, the inside of each of the plurality of closed spaces 70 is in a gas state. That is, the inside of each of the plurality of closed spaces 70 has a refractive index ***n*** = approximately 1.0. That is, each of the plurality of closed spaces 70 has a smaller refractive index than the resin material 60.

For example, as illustrated in FIG. 3, a radiated light LM1 that enters the resin material 60 from the light-emitting element 20 or the wavelength converter 40 and is incident on an interface of each of the plurality of closed spaces 70 from the resin material 60 at a low angle is totally reflected by a refractive index difference between the resin material 60 and the plurality of closed spaces 70. The totally reflected radiated light LM1 is returned again to a direction of the wavelength converter 40.

Moreover, a radiated light LM2 that enters the resin material 60 from the light-emitting element 20 or the wavelength converter 40 and is incident on the interface of each of the plurality of closed spaces 70 from the resin material 60 at a high angle is scattered by the plurality of closed spaces 70.

Specifically, as described above, the light-emitting element 20 is a blue LED that radiates blue light from a nitride semiconductor. That is, the light-emitting element 20 is a light-emitting element that radiates blue light having a wavelength of wavelength λ equal to approximately 460 nm to 500 nm. The wavelength converter 40 is a wavelength converter containing a YAG:Ce phosphor. That is, the wavelength converter 40 is a wavelength converter that absorbs the light radiated from the light-emitting element 20 and radiates light having a wavelength of the wavelength λ equal to approximately 500 nm to 700 nm as a tendency. Each of the plurality of closed spaces 70 has, for example, an average diameter of approximately 200 nm to 300 nm. That is, the radiated light LM2 is subject to Mie scattering by the plurality of closed spaces 70, and the scattered light is returned again to the direction of the wavelength converter 40.

Therefore, as described above, the resin material 60 and the plurality of closed spaces 70 function as the light reflector by the total reflection at the interface between the resin material 60 and each of the plurality of the closed spaces 70 and Mie scattering by the plurality of closed spaces 70.

Thus, in Embodiment 1, as the light reflector in which reflected particles having a photocatalytic effect of titanium oxide and the like are not used inside resin, the resin material 60 having the plurality of closed spaces 70 can be selected. This can suppress deterioration, such as yellowing of the resin material 60 and resin reduction due to cracks and depolymerization when the light-emitting device 100 is driven on a long-term basis.

Moreover, in Embodiment 1, as the light reflector in which reflected particles, such as metal particles, are not used inside resin, the resin material 60 having the plurality of closed spaces 70 can be selected. This can suppress a decrease in elastic modulus after heat curing of the resin material 60 and can suppress generation of, for example, cracks of the resin material 60 and flaking from the substrate 10, the light-emitting element 20, or the wavelength converter 40.

Accordingly, the light-emitting device 100 allows suppressing the deterioration of a light-reflective resin material and improving long-term reliability.

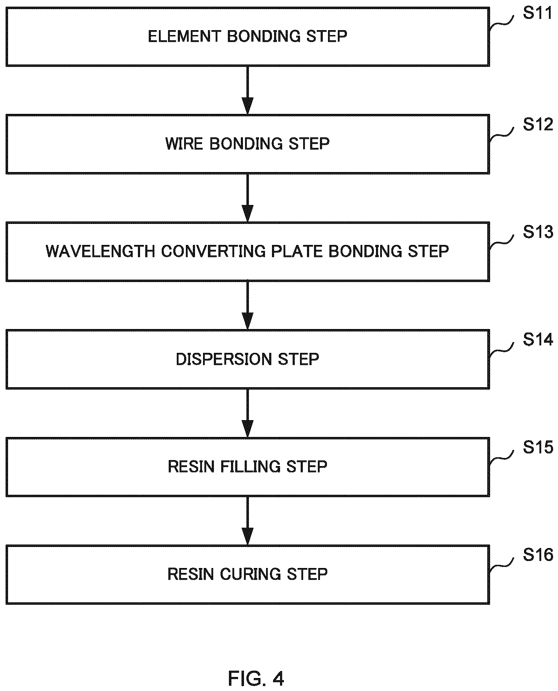

Next, an exemplary manufacturing procedure of the light-emitting device 100 is described using FIG. 4 to FIG. 6.

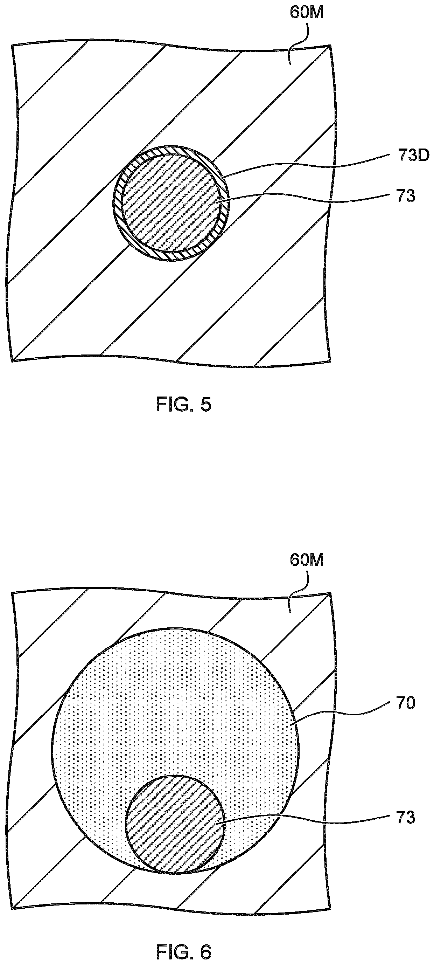

FIG. 4 is a diagram illustrating a manufacturing process of the light-emitting device 100 according to Embodiment 1 of the present invention. FIG. 5 and FIG. 6 illustrate enlarged views of the resin body 73 inside the resin material 60 in the manufacturing procedure illustrated in FIG. 4.

First, as illustrated in FIG. 1 and FIG. 2, the light-emitting element 20 is bonded to the substrate 10 (Step S11: element bonding step). In this step, the substrate 10, which has a cavity formed with the flat plate portion 11 and the frame body portion 13 and in which the first wiring 15 and the second wiring 17 are formed, are prepared. An AuSn paste is applied over the upper surface of the first internal wiring 15I using a dispenser filled with the AuSn paste. The light-emitting element 20 is placed on the upper surface of the first internal wiring 15I so that a cathode electrode (not illustrated) disposed on the lower surface of the light-emitting element 20 comes into contact with the AuSn paste.

The substrate 10 in this state is, for example, overheated to 300°C in a nitrogen atmosphere to melt AuSn alloy particles in the AuSn paste and then is cooled. This causes the light-emitting element 20 and the first internal wiring 15I to be firmly fixed. The light-emitting element 20 and the first internal wiring 15I are joined by eutectic bonding by an AuSn alloy and electrically connected to one another.

The position and orientation to which the light-emitting element 20 is fixed are self-aligned by surface tension of the melted AuSn alloy. Specifically, between the heated and melted AuSn alloy and the light-emitting element 20, the light-emitting element 20 is self-aligned by the surface tension with which the interfacial energy of the melted AuSn alloy is minimal.

Note that bonding of the light-emitting element 20 is not limited to this, and a conductive adhesive made from AuSn bumps that do not contain flux, an AuSn sheet, or an AuSn deposition layer preliminarily formed on the lower surface of each element as a raw material may be used. In addition, a conductive adhesive, such as a silver paste or solder, may be used.

Next, as illustrated in FIG. 1 and FIG. 2, the bonding wire BW is bonded so as to connect the electrode pad 25 of the light-emitting element 20 to the second internal wiring 17I (Step S12: wire bonding step) . In this step, the substrate 10 to which the light-emitting element 20 is bonded is set on a wire bonding device, and the bonding wire BW, such as an Au wire, is bonded across the electrode pad 25 of the light-emitting element 20 and the second internal wiring 17I. This electrically connects the anode electrode of the light-emitting element 20 to the second wiring 17 via the bonding wire BW.

Next, as illustrated in FIG. 1 and FIG. 2, the wavelength converter 40 is bonded on the semiconductor layer of the light-emitting element 20 via the adhesive layer 50 (Step S13: wavelength converter bonding step). In this step, using a dispenser filled with a paste that becomes a raw material of the adhesive layer 50, the paste is applied over the semiconductor layer of the light-emitting element 20. Afterwards, the wavelength converter 40 is placed on the semiconductor layer so as to bring the paste into contact with the lower surface of the wavelength converter 40. The wavelength converter 40 is placed by positioning it at a position to cover the semiconductor layer. The substrate 10 in this state is heated to cure the raw material of the adhesive layer 50, and the light-emitting element 20 and the wavelength converter 40 are bonded.

Next, a dispersion step of dispersing the resin bodies 73 in a precursor 60M of the resin material 60 is performed (Step S14: dispersion step). In other words, the manufacturing method of the light-emitting device 100 includes the dispersion step of dispersing the resin bodies 73 having a dispersant containing a higher alcohol in the precursor 60M of the resin material 60 made of a translucent thermosetting resin.

In this step, first, the precursor 60M as a raw material resin of the resin material 60 made of a thermosetting silicone resin and the resin bodies 73 covered with the dispersant as a coating containing a higher alcohol that evaporates at a lower temperature than a thermal curing temperature of the precursor 60M are prepared. The precursor 60M and the resin bodies 73 covered with the dispersant are mixed using, for example, a kneading machine to disperse the resin bodies 73 covered with the dispersant in the precursor 60M. Note that the order of this step is not limited to this, and the step may be performed before Step S13 or may be performed concurrently with Step S13.

Next, as illustrated in FIG. 2, a resin material arranging step is performed for filling the precursor 60M in which the resin bodies 73 covered with the dispersant are dispersed in the cavity of the substrate 10 (Step S15: resin filling step). In this step, using a dispenser filled with the precursor 60M, the precursor 60M is injected into the cavity formed with the flat plate portion 11 and the frame body portion 13 and filled so as to cover the side surfaces of the light-emitting element 20 and the wavelength converter 40. In other words, the manufacturing method of the light-emitting device 100 includes the resin material arranging step of arranging the precursor 60M of the resin material 60 at the peripheral area of the light-emitting element 20 on the substrate 10.

Next, a heating processing step is performed for heating the substrate 10 with the cavity filled with the precursor 60M and heating and curing the precursor 60M to form the resin material 60 and form the plurality of closed spaces 70 (Step S16: resin curing step). In other words, the manufacturing method of the light-emitting device 100 includes the heating processing step of heating and curing the precursor 60M of the resin material 60 and evaporating the higher alcohol contained in a dispersant 73D to form the closed spaces 70 in the resin material 60.

Using FIG. 5 and FIG. 6, a method for forming the plurality of closed spaces 70 in the resin material 60 is described in detail.

FIG. 5 is an enlarged cross-sectional view of the resin body 73 at the time of filling the precursor 60M in the cavity of the substrate 10 in Step S15. FIG. 6 is an enlarged cross-sectional view of the resin body 73 in the middle of heating and curing the precursor 60M in Step S16.

As illustrated in FIG. 5, at the time of dispersing the resin bodies 73 in the precursor 60M of the resin material 60, the resin bodies 73 are covered with the dispersant 73D containing a higher alcohol. In Step S15, the precursor 60M in this state is filled in the cavity of the substrate 10.

Next, in Step S16, the resin material 60, the resin bodies 73, and the dispersant 73D are heated. As described above, the higher alcohol contained in the dispersant 73D evaporates at a lower temperature than the thermal curing temperature of the precursor 60M. This causes the higher alcohol contained in the dispersant 73D to evaporate as illustrated in FIG. 6, and pressure increased at the time of the evaporation pushes to open up the precursor 60M, forming the plurality of closed spaces 70 that are spaces containing the higher alcohol in a gas state. The precursor 60M in which the plurality of closed spaces 70 are formed is further heated and thermally cured in this state and becomes the resin material 60 with the plurality of closed spaces 70 remaining formed.

The dispersant 73D may partially return to a liquid state and remain inside each of the plurality of closed spaces 70 after the process of Step S16, that is, when the resin material 60 is cooled.

The light-emitting device 100 is manufactured by processing the above steps of Steps S11 to S16.

With Embodiment 1, by dispersing the resin bodies 73 covered with the dispersant 73D containing a higher alcohol in the precursor 60M of the resin material 60 and heating this, the light reflector made of the resin material 60 having the plurality of closed spaces 70 can be formed.

Thus, in Embodiment 1, as the light reflector in which reflected particles having a photocatalytic effect of titanium oxide and the like are not used inside resin, the resin material 60 having the plurality of closed spaces 70 can be selected. This can suppress deterioration, such as yellowing of the resin material 60 and resin reduction due to cracks and depolymerization when the light-emitting device 100 is driven on a long-term basis.

Moreover, in Embodiment 1, as the light reflector in which reflected particles, such as metal particles, are not used inside resin, the resin material 60 having the plurality of closed spaces 70 can be selected. This can suppress a decrease in elastic modulus after heat curing of the resin material 60 and can suppress generation of, for example, cracks of the resin material 60 and flaking from a supporting body and the like.

Accordingly, the light-emitting device 100 allows suppressing the deterioration of a light-reflective resin material and improving long-term reliability.

### Embodiment 2

In Embodiment 1, the case where the plurality of closed spaces 70 are formed by evaporating the higher alcohol contained in the dispersant for the resin bodies 73 has been described. However, the forming method of the plurality of closed spaces 70 is not limited to this.

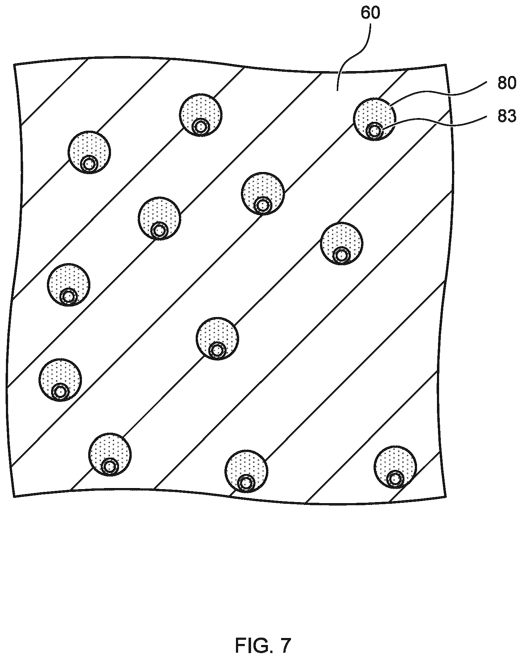

FIG. 7 is an enlarged cross-sectional view of an enlarged part of the resin material 60 and a plurality of closed spaces 80 of a light-emitting device 100A according to Embodiment 2.

The light-emitting device 100A basically has a similar configuration to the light-emitting device 100 of Embodiment 1. The light-emitting device 100A is different from the light-emitting device 100 in that resin bodies 83 that reside in the plurality of closed spaces 80 are thermally expandable particles. In other words, the resin bodies 83 are thermally expandable particles.

Inside the resin material 60, the plurality of closed spaces 80 are formed in a dispersed manner. The resin body 83 having an outer shape smaller than a diameter of each closed space 80 resides in an inside of each of the plurality of closed spaces 80.

For the resin body 83, for example, a thermally expandable microcapsule made of a core material 83C and the resin body 83 as a shell material covering the core material 83C is used as a material. The core material 83C contains a low-molecular-weight hydrocarbon having a boiling point lower than the temperature at which the precursor 60M of the resin material 60 is thermally cured. Each inside of each closed space 80 and each inside of the resin body 83 contains an organic matter, such as a low-molecular-weight hydrocarbon, in a gas state that is the core material 83C evaporated when the precursor 60M is thermally cured. That is, the resin body 83 is a shell material of the hollow thermally expandable microcapsule.

The core material 83C contains, for example, a low-molecular-weight hydrocarbon, such as n-pentane and isopentane, having a boiling point lower than the temperature at which the precursor 60M of the resin material 60 is thermally cured. The resin body 83 is a shell material made of acrylonitrile/methacrylonitrile copolymer formed so as to cover the core material 83C.

For example, by heating the thermally expandable microcapsule, the low-molecular-weight hydrocarbon contained in the core material 83C evaporates. The low-molecular-weight hydrocarbon evaporates, thereby increasing the internal pressure of the resin body 83. By further heating, the acrylonitrile/methacrylonitrile copolymer of the resin body 83 is softened, and the resin body 83 expands in a balloon shape. Afterwards, the low-molecular-weight hydrocarbon in a gas state in the resin body 83 permeates the resin body 83, which has expanded and decreased in thickness, and is discharged out of the resin body 83. The resin body 83 shrinks in association with the discharge of the low-molecular-weight hydrocarbon.

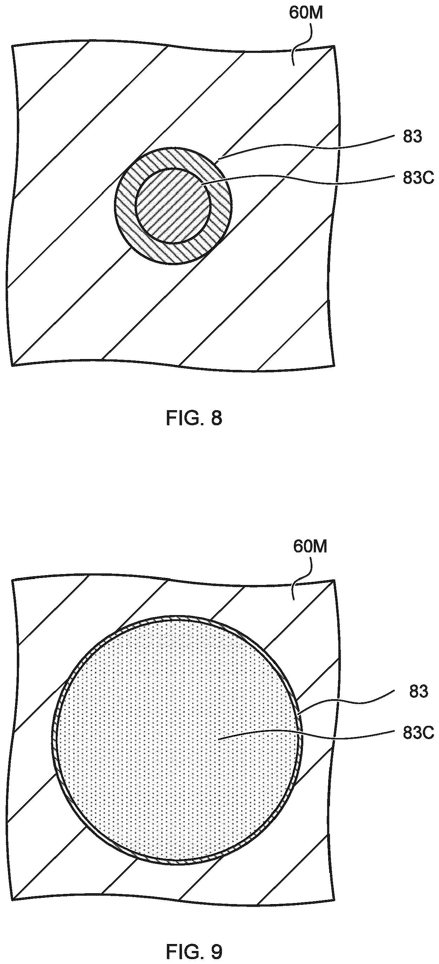

Using FIG. 8 to FIG. 10, the following describes a method for forming each of the closed spaces 80 using the thermally expandable microcapsule by following the description of the manufacturing method illustrated in FIG. 4. The manufacturing method of the light-emitting device 100A is basically similar to that of the light-emitting device 100 of Embodiment 1.

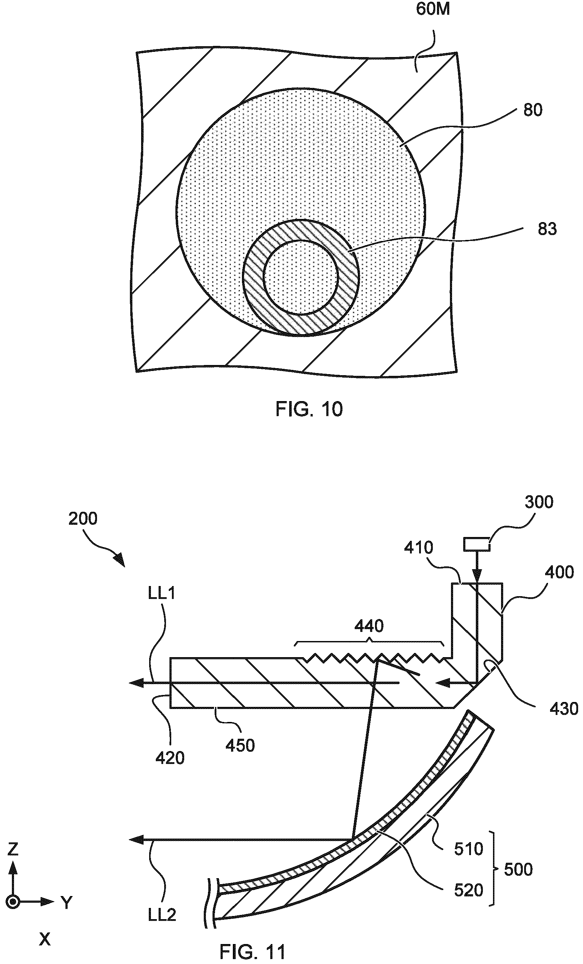

FIG. 8 is an enlarged cross-sectional view of the thermally expandable microcapsule in the dispersion step of Step S14 and the filling step of Step S15. FIG. 9 and FIG. 10 are enlarged cross-sectional views of the thermally expandable microcapsule in the middle of heating and curing the precursor 60M in Step S16.

In the dispersion step of Step S14, the thermally expandable microcapsules are dispersed in the precursor 60M of the resin material 60 (Step S14: dispersion step). In other words, the manufacturing method of the light-emitting device 100A includes the dispersion step of dispersing the thermally expandable microcapsules as thermally expandable particles in the precursor 60M of the resin material 60 made of a translucent thermosetting resin.

Next, in Step S15, the precursor 60M in which the thermally expandable microcapsules are dispersed is filled in the cavity of the substrate 10 (Step S15: filling step).

As illustrated in FIG. 8, at the time of dispersing the thermally expandable microcapsules in the precursor 60M of the resin material 60 in Step S14, the resin body 83 of the thermally expandable microcapsule internally contains the core material 83C made of a liquid low-molecular-weight hydrocarbon.

Next, a heating processing step is performed for heating the substrate 10 with the cavity filled with the precursor 60M and heating and curing the precursor 60M to form the resin material 60 and form the plurality of closed spaces 80 (Step S16: resin curing step). In other words, the manufacturing method of the light-emitting device 100A includes the heating processing step of heating and curing the precursor 60M of the resin material 60 and expanding the thermally expandable microcapsules as thermally expandable particles to form the plurality of closed spaces 80 in the resin material 60.

In this step, the resin material 60, the resin bodies 83, and the core materials 83C are heated. As described above, the low-molecular-weight hydrocarbon contained in the core material 83C evaporates at a lower temperature than the thermal curing temperature of the precursor 60M. This causes the low-molecular-weight hydrocarbon contained in the core material 83C to evaporate as illustrated in FIG. 9, and pressure increased at the time of the evaporation expands the resin body 83 and pushes to open up the precursor 60M. Afterwards, the evaporated core material 83C permeates the resin body 83, which has expanded and decreased in thickness, and the resin body 83 shrinks. That is, as illustrated in FIG. 10, each of the closed spaces 80 is formed inside the precursor 60M. Each inside of each of the closed spaces 80 includes the shrunk resin body 83 and contains the core material 83C in a gas state. The precursor 60M in which the respective closed spaces 80 are formed is further heated and thermally cured in this state and becomes the resin material 60 with the respective closed spaces 80 remaining formed.

The core material 83C may partially return to a liquid state and remain inside each of the respective closed spaces 80 and resin bodies 83 after the process of Step S16, that is, when the resin material 60 is cooled.

With Embodiment 2, by dispersing the thermally expandable microcapsules in the precursor 60M of the resin material 60 and heating this, the light reflector made of the resin material 60 having the plurality of closed spaces 80 can be formed.

Thus, in Embodiment 2, as the light reflector in which reflected particles having a photocatalytic effect of titanium oxide and the like are not used inside resin, the resin material 60 having the plurality of closed spaces 80 can be selected. This can suppress deterioration, such as yellowing of the resin material 60 and resin reduction due to cracks and depolymerization when the light-emitting device 100A is driven on a long-term basis.

Moreover, in Embodiment 2, as the light reflector in which reflected particles, such as metal particles, are not used inside resin, the resin material 60 having the plurality of closed spaces 80 can be selected. This can suppress a decrease in elastic modulus after heat curing of the resin material 60 and can suppress generation of, for example, cracks of the resin material 60 and flaking from the substrate 10, the light-emitting element 20, or the wavelength converter 40.

Accordingly, the light-emitting device 100A allows suppressing the deterioration of a light-reflective resin material and improving long-term reliability.

In the embodiment, the case where the thermally expandable microcapsules are used as an example of thermally expandable particles has been described. However, the thermally expandable particles forming the closed spaces 80 are not limited to the thermally expandable microcapsules and need only be thermally expandable particles that shrink after expanding to form the closed spaces 80. For example, the thermally expandable particles need only be thermally expandable particles that expand at a lower temperature than the thermal curing temperature of the precursor 60M and shrink during cooling after the thermal curing of the precursor 60M. In that case, in the manufacturing method of the light-emitting device 100A, the thermally expandable particles shrink during cooling after the resin curing step of Step S16 is completed to form the closed spaces 80. In that case, the inside of the closed space 80 may be in a pressure-reduced gas state. Even when the inside of the closed space 80 is in a pressure-reduced gas state, the refractive index n = approximately 1.0 inside the closed space 80, and therefore, the function as the light reflector is similar to Embodiments 1 and 2.

In Embodiment 1 and Embodiment 2, the case where the light-emitting devices 100 have the adhesive layer 50 and the wavelength converter 40 disposed on the light-emitting element 20 has been described. However, in the present invention, the wavelength converter 40 and the adhesive layer 50 can be disposed arbitrarily. For example, in a case where the light radiated from the light-emitting element 20 is used without converting the wavelength, or the like, the wavelength converter 40 and the adhesive layer 50 need not be disposed in the light-emitting device 100.

Further, in Embodiment 1 and Embodiment 2, the case where the resin material 60 is arranged so as to cover the side surfaces of the light-emitting element 20 has been described. However, in the light-emitting device 100 of the present invention, the resin material 60 is not limited to the position in contact with the side surfaces of the light-emitting element 20 or a lateral position of the light-emitting element 20 and may be disposed at any of the positions that lies at the peripheral area of the light-emitting element 20 and receives the light radiated from the light-emitting element 20. That is, in the light-emitting device 100, the resin material 60 may be appropriately disposed at a desired position that reflects the light radiated from the light-emitting element 20. For example, the resin material 60 can be arranged so as to cover a part of the side surfaces and the upper surface of the light-emitting element 20 to configure a side light-emitting type light-emitting device 100.

In the light-emitting device 100 of the present invention, the resin material 60 is not limited to being arranged in close contact with the light-emitting element 20. For example, the resin material 60 may be arranged at the peripheral area (outer sides) of the light-emitting element 20 covered with another translucent sealing material.

### [Application Example]

The resin material 60 having the plurality of closed spaces 70 illustrated in Embodiment 1 and the resin material 60 having the closed spaces 80 illustrated in Embodiment 2 are not limited to the light reflectors of the light-emitting devices 100 and 100A and are applicable as light-reflective materials for other fields.

FIG. 11 is a diagram illustrating a cross-sectional view of a vehicle lamp 200 as an example of an irradiation device in which a material similar to that used in the above-described resin material 60 is used as a light-reflective material.

The vehicle lamp 200 as an irradiation device has a light source unit 300, a light guiding body 400, and a reflector 500.

The light source unit 300 is, for example, a light source unit including a light-emitting device, such as an LED. For example, the light source unit 300 is linearly arrayed in an X-direction in the drawing. In the application example, the light source unit 300 is a light source unit that radiates light in a downward direction (-Z-direction).

The light guiding body 400 is, for example, a light guiding body that is made of a translucent resin material, such as acrylic, and guides the light radiated from the light source unit 300. For example, the light guiding body 400 has an incident surface 410 on which the light emitted from the light source unit 300 is incident inside the light guiding body 400 and an emitting surface 420 from which the light incident inside the light guiding body 400 is emitted. For example, the light guiding body 400 has an approximately L-shaped cross-sectional shape, and a light reflecting surface 430 is formed at a bent portion of the approximate L-shape. The light emitted from the light source unit 300 is incident inside the light guiding body 400 from the incident surface 410 of the light guiding body 400, totally reflected at the light reflecting surface 430, and guided to a direction of the emitting surface 420. The light guided to the direction of the emitting surface 420 is emitted from the emitting surface 420 of the light guiding body 400 to an outside (-Y-direction) of the vehicle lamp 200 as a main orientation LL1 of the vehicle lamp 200.

The light guiding body 400 has a diffuse reflecting surface 440 in a region between the light reflecting surface 430 and the emitting surface 420. A part of the light totally reflected at the light reflecting surface 430 is incident on the diffuse reflecting surface 440, diffusely reflected, and emitted from a diffusion light emitting surface 450 that is a lower surface of the light guiding body 400 to a direction of the reflector 500.

The reflector 500 is a light reflector constituted of a supporting body 510 and a light-reflective material 520. In the application example, a material similar to the resin material 60 having the closed spaces used in the above-described Embodiments 1 and 2 is used for the light-reflective material 520 of the reflector 500.

The supporting body 510 is, for example, made of a material, such as resin, and has a recessed concave surface in a form of a radiant surface, an elliptical surface, or a spherical surface on a surface opposed to the diffusion light emitting surface 450 of the light guiding body 400. A thermosetting silicone resin and the light-reflective material 520 formed by dispersing a plurality of closed spaces in the silicone resin are applied over the concave surface of the supporting body 510.

The light-reflective material 520 is a light-reflective material constituted of the resin material 60, the plurality of closed spaces 70, and the resin bodies 73 illustrated in Embodiment 1 and a light-reflective material constituted of the resin material 60, the plurality of closed spaces 80, and the resin bodies 83 illustrated in Embodiment 2. In other words, the light-reflective material 520 is made of the resin material 60 as a translucent thermosetting resin that has the plurality of closed spaces 70 or 80, each of which holds the resin body 73 or 83.

The light emitted from the diffusion light emitting surface 450 of the light guiding body 400 is reflected in a direction parallel to the main orientation LL1 by the light-reflective material 520 applied over the concave surface of the supporting body 510 and emitted to the outside (-Y-direction) of the vehicle lamp 200 as a sub-orientation LL2.

This allows the vehicle lamp 200 to emit the light including the main orientation LL1 and the sub-orientation LL2 toward a desired direction.

Note that a forming method of the light-reflective material 520 is similar to the method described in Embodiments 1 and 2. Specifically, the precursor 60M of the resin material 60, in which the resin bodies 73 or the thermally expandable microcapsules constituted of the resin bodies 83 is dispersed, is applied over the supporting body 510 using a method, such as spray coating. The resin body 73 is covered with the dispersant 73D containing a higher alcohol. The resin body 83 internally contains the core material 83C made of a liquid low-molecular-weight hydrocarbon. Afterwards, by heating the supporting body 510 in this state, the precursor 60M is thermally cured, and the plurality of closed spaces 70 or the plurality of closed spaces 80 are formed.

Each of the light-reflective material constituted of the resin material 60, the plurality of closed spaces 70, and the resin bodies 73 illustrated in Embodiment 1 and the light-reflective material constituted of the resin material 60, the plurality of closed spaces 80, and the resin bodies 83 illustrated in Embodiment 2 is applicable as a light-reflective material for a vehicle lamp.

Usually, the light-reflective material used for the reflector of a vehicle lamp is, for example, a metal deposition film on which argentum (Ag), aluminum (Al), or the like is evaporatively deposited on the supporting body 510. By using a light-reflective material constituted of a resin material and a plurality of closed spaces as described in the application example, the manufacturing cost of the vehicle lamp can be reduced.

Further, by using a light-reflective material constituted of a resin material, a plurality of closed spaces, and resin bodies for the light-reflective material of the reflector 500, deterioration, such as yellowing of the resin material and resin reduction due to cracks and depolymerization when the vehicle lamp 200 is driven on a long-term basis can be suppressed. In addition, deterioration, such as yellowing of the supporting body 510 similarly made of a resin material and resin reduction due to cracks and depolymerization can be suppressed. Further, a decrease in elastic modulus after heat curing of the resin material of the light-reflective material can be suppressed, and generation of, for example, cracks of the resin material and flaking from a supporting body and the like can be suppressed.

Accordingly, the light-reflective material 520 allows suppressing the deterioration of the light-reflective resin material and improving long-term reliability of the vehicle lamp 200 as an irradiation device.

Each of the light-reflective material constituted of the resin material 60, the plurality of closed spaces 70, and the resin bodies 73 illustrated in Embodiment 1 and the light-reflective material constituted of the resin material 60, the plurality of closed spaces 80, and the resin bodies 83 illustrated in Embodiment 2 is not limited to the application to a vehicle lamp and is further applicable as a light-reflective material in other fields. Specifically, a thermosetting resin can be used for the resin body of the light-reflective material and is applicable in any of the fields that require light to be reflected.

### DESCRIPTION OF REFERENCE SIGNS

- 100: Light-emitting device
- 10: Substrate
- 11: Flat plate portion
- 13: Frame body portion
- 15: First wiring
- 17: Second wiring
- 20: Light-emitting element
- 25: Electrode pad
- 30: Element bonding layer
- 40: Wavelength converter
- 50: Adhesive layer
- 60: Resin material
- 70, 80: Closed space
- 73, 83: Resin body
- 200: Vehicle lamp
- 300: Light source unit
- 400: Light guiding body
- 410: Incident surface
- 420: Emitting surface
- 430: Light reflecting surface
- 440: Diffuse reflecting surface
- 500: Reflector
- 510: Supporting body
- 520: Light-reflective material

## Claims

1. A light-emitting device comprising:
a substrate;
a light-emitting element disposed on the substrate; and
a resin material made of a translucent thermosetting resin disposed at a peripheral area of the light-emitting element, wherein
the resin material has a plurality of closed spaces, and
each of the plurality of closed spaces holds a resin body.

2. The light-emitting device according to claim 1, wherein
the plurality of closed spaces internally contain an organic matter.

3. The light-emitting device according to claim 2, wherein
the organic matter is a higher alcohol.

4. The light-emitting device according to claim 2 or 3, wherein
the organic matter is an organic matter that evaporates at a temperature lower than a thermal curing temperature of the resin material.

5. The light-emitting device according to any one of claims 1 to 4, wherein
the resin body is a silicone resin.

6. The light-emitting device according to claim 1 or 2, wherein
the resin body is thermally expandable particles.

7. The light-emitting device according to any one of claims 1 to 6, wherein
each of the plurality of closed spaces has a diameter average value of 200 nm to 300 nm.

8. A manufacturing method of a light-emitting device including a substrate, a light-emitting element disposed on the substrate, and a wavelength converter disposed on an upper surface of the light-emitting element, the manufacturing method comprising:
a dispersion step of dispersing a resin body having a coating containing a higher alcohol in a resin material made of a translucent thermosetting resin;
a resin material arranging step of arranging the resin material at a peripheral area of the light-emitting element on the substrate; and
a heating processing step of heating and curing the resin material and evaporating the higher alcohol to form a closed space in the resin material.

9. A manufacturing method of a light-emitting device including a substrate and a light-emitting element disposed on the substrate, the manufacturing method comprising:
a dispersion step of dispersing thermally expandable particles in a resin material made of a translucent thermosetting resin;
a resin material arranging step of arranging the resin material at a peripheral area of the light-emitting element on the substrate; and
a heating processing step of heating and curing the resin material and expanding the thermally expandable particles to form a closed space in the resin material.

10. A light-reflective material comprising
a translucent thermosetting resin having a plurality of closed spaces, and
each of the plurality of closed spaces holds a resin body.

11. An irradiation device comprising:
a light source; and
a light-reflective material disposed at a position on which light emitted from the light source is incident, wherein
the light-reflective material is made of a translucent thermosetting resin having a plurality of closed spaces, and
each of the plurality of closed spaces holds a resin body.
